# FASCICULE DE BREVET EUROPEEN

(11) **EP 3 895 221 B1**
(45) Date de publication et mention de la délivrance du brevet: **31.08.2022**
(21) Numéro de dépôt: 19839391.0
(22) Date de dépôt: 11.12.2019
(51) Int. Cl.: H01L 31/048

(54) **PROCEDE DE FABRICATION D'UN MODULE PHOTOVOLTAÏQUE**
VERFAHREN ZUR HERSTELLUNG EINES FOTOVOLTAIKMODULS
METHOD FOR MANUFACTURING A PHOTOVOLTAIC MODULE

(30) Priorité: 13.12.2018 FR 1872850
(43) Date de publication de la demande: 20.10.2021
(73) Titulaire: Commissariat à l'Energie Atomique et aux Energies Alternatives, 75015 Paris (FR)
(72) Inventeur: BARBOT, Anthony, 38054 GRENOBLE cedex 09 (FR); ROUJOL, Yannick, 38054 GRENOBLE cedex 09 (FR); SERAINE, Caroline, 38054 GRENOBLE cedex 09 (FR)
(74) Mandataire: INNOV-GROUP
(86) Numéro de dépôt international: PCT/FR2019/053026
(87) Numéro de publication internationale: WO 2020/120908

(56) Documents cités:
- JP-A- 2013 235 932
- US-A- 4 057 439

## Description

### Domaine technique de l'invention

Le domaine technique de l'invention concerne le domaine photovoltaïque, notamment relatif aux modules photovoltaïques. Notamment, l'invention est relative à un procédé de fabrication d'un module photovoltaïque.

### Etat de la technique

Afin de préserver les cellules photovoltaïques d'un module photovoltaïque, il est classique de les encapsuler. L'encapsulation des cellules photovoltaïques permet par exemple de les protéger de la pluie, du vent, de la neige, de l'humidité, des rayonnements ultraviolets.

Pour cela, il est connu de former un empilement comportant successivement : un élément de protection arrière, un film d'éthylène acétate de vinyle (EVA), des cellules photovoltaïques reliées électriquement entre elles, un film d'éthylène acétate de vinyle (EVA), un élément de protection avant comme par exemple une plaque de verre. L'élément de protection avant est destiné à recevoir le rayonnement solaire avant que ce dernier ne coopère avec les cellules photovoltaïques pour générer de l'énergie électrique. Cet empilement est ensuite laminé à chaud pour faire fondre les films en EVA et provoquer la réticulation de l'EVA fondu d'où il résulte la formation d'une enveloppe d'encapsulation solide des cellules photovoltaïques collée aux éléments de protection avant et arrière. L'utilisation de l'EVA présente l'avantage de faciliter la fabrication d'un module photovoltaïque en utilisant une lamination réalisée à chaud de l'empilement. Cependant, l'EVA présente comme inconvénient de générer de l'acide acétique lors de sa réticulation au cours de la lamination, cet acide acétique provoquant l'érosion des électrodes des cellules photovoltaïques. L'EVA présente aussi l'inconvénient de jaunir dans le temps du fait de son exposition aux rayonnements ultraviolets. Par ailleurs, l'EVA présente l'inconvénient d'être associé à une gamme étroite de température d'utilisation qui rend son utilisation incompatible dans un environnement spatial.

Le brevet américain US4,057,439 décrit une solution d'encapsulation à base de silicone. Le problème de cette solution est qu'elle met en œuvre une encapsulation par voie liquide pouvant générer des bulles de gaz, notamment des bulles d'air, au sein de l'encapsulant et rendant difficile la maîtrise de l'épaisseur de l'encapsulant. Les bulles de gaz peuvent provoquer l'éclatement du module photovoltaïque lorsqu'il sera déployé hors de l'atmosphère terrestre dans une application spatiale du fait d'une différence de pression entre les bulles de gaz et l'extérieur du module photovoltaïque. Pour une application terrestre, la présence des bulles est aussi néfaste car au-delà de simples problèmes d'esthétisme, les bulles peuvent induire une moins bonne transmission du rayonnement solaire vers les cellules photovoltaïques si ces bulles se sont formées au-dessus des cellules photovoltaïques (le rayonnement solaire peut alors en partie être réfléchi). Par ailleurs, les bulles peuvent aussi induire une moins bonne dissipation thermique du module photovoltaïque, pouvant ainsi engendrer instantanément une perte d'efficacité des cellules photovoltaïques. Un autre inconvénient de la présence de bulles est qu'elles peuvent favoriser à terme la délamination du module photovoltaïque.

Il est connu le document JP 2013 235932 A concernant un procédé d'encapsulation de cellules photovoltaïques par résine silicone.

### Objet de l'invention

L'invention a pour but un procédé de fabrication d'un module photovoltaïque permettant notamment d'améliorer l'encapsulation d'une cellule photovoltaïque de ce module photovoltaïque en limitant la formation de bulles de gaz lors de l'encapsulation de la cellule photovoltaïque et/ou en facilitant la maîtrise de l'épaisseur de l'encapsulant de la cellule photovoltaïque.

A cet effet, l'invention est relative à un procédé de fabrication d'un module photovoltaïque comportant au moins une cellule photovoltaïque, ce procédé de fabrication étant caractérisé en ce qu'il comporte une étape d'encapsulation de la cellule photovoltaïque comprenant la formation d'un empilement comportant :
- la cellule photovoltaïque,
- un film d'encapsulation à base d'un matériau polymère réticulé au moins à son point de gel,
- une couche d'adhésion à base d'un matériau polymère réticulable, la couche d'adhésion étant destinée à coller le film d'encapsulation à la cellule photovoltaïque,
et le procédé de fabrication comporte une étape de réticulation comportant la réticulation du matériau polymère réticulable de la couche d'adhésion.

Un avantage d'un tel procédé de fabrication réside dans l'utilisation d'un film d'encapsulation réticulé au moins à son point de gel permettant ainsi de limiter la quantité de produit réticulable, notamment à l'état liquide, à utiliser pour limiter la formation de bulles de gaz lors de l'encapsulation. Par ailleurs, le film d'encapsulation étant réticulé au moins à son point de gel, ce dernier ne va pas fondre lors du procédé de fabrication, cela permet de mieux maîtriser l'épaisseur d'encapsulant à terme au sein du module photovoltaïque, et cela permet d'éviter la formation de nouvelles bulles de gaz au sein de ce film d'encapsulation car il ne va pas changer d'état (solide vers liquide) lors de la fabrication. En effet, le changement d'état de solide vers liquide puis vers solide peut induire la présence de bulles de gaz si le procédé, par exemple la lamination, n'est pas optimisé de manière adéquate.

Le procédé de fabrication peut en outre comporter une ou plusieurs des caractéristiques suivantes :
- le procédé de fabrication comporte une étape de formation de la couche d'adhésion sur le film d'encapsulation avant de mettre en contact la couche d'adhésion avec la cellule photovoltaïque ;
- le matériau polymère réticulé au moins à son point de gel du film d'encapsulation et le matériau polymère réticulable de la couche d'adhésion sont respectivement choisi parmi la famille des silicones ;
- l'étape d'encapsulation comporte une étape de lamination de l'empilement mettant en œuvre l'étape de réticulation ;
- la formation de l'empilement est telle que ledit empilement comporte : une première partie comportant ledit film d'encapsulation et ladite couche d'adhésion ; une deuxième partie comportant un film d'encapsulation additionnel à base d'un matériau polymère réticulé au moins à son point de gel et une couche d'adhésion additionnelle à base d'un matériau polymère réticulable destinée à coller le film d'encapsulation additionnel à la cellule photovoltaïque ; la cellule photovoltaïque interposée entre les première et deuxième parties ; et l'étape de réticulation comporte la réticulation du matériau polymère réticulable de la couche d'adhésion additionnelle, il résulte de l'étape de réticulation l'encapsulation de la cellule photovoltaïque entre le film d'encapsulation et le film d'encapsulation additionnel ;
- la formation de l'empilement est telle que l'empilement comporte des premier et deuxième éléments de protection entre lesquels sont agencées les première et deuxième parties de l'empilement, la première partie de l'empilement comportant une couche de collage à base d'un matériau polymère réticulable destinée coller le film d'encapsulation au premier élément de protection, et la deuxième partie comportant une couche de collage additionnelle à base d'un matériau polymère réticulable destinée à coller le film d'encapsulation additionnel au deuxième élément de protection, et l'étape de réticulation comporte la réticulation du matériau polymère réticulable de la couche de collage et du matériau polymère réticulable de la couche de collage additionnelle de telle sorte qu'il résulte de l'étape de réticulation la formation d'une enveloppe d'encapsulation de la cellule photovoltaïque collée aux premier et deuxième éléments de protection ;
- le film d'encapsulation et le film d'encapsulation additionnel sont troués de sorte qu'au sein de l'empilement : les couches d'adhésion et de collage sont reliées entre elles au niveau des trous du film d'encapsulation, notamment par du matériau polymère réticulable présent dans lesdits trous ; les couches d'adhésion et de collage additionnelles sont reliées entre elles au niveau des trous du film d'encapsulation additionnel, notamment par du matériau polymère réticulable présent dans lesdits trous ;
- au moins l'un des premier et deuxième élément de protection est déformable de telle sorte qu'il subit une déformation au cours de l'étape de lamination ;
- après l'étape de lamination, le procédé de fabrication comporte une étape de collage d'un support sur le premier élément de protection déformé ou sur le deuxième élément de protection déformé ;
- la formation de l'empilement comporte : une étape de fourniture d'un substrat souple comportant au moins une portion imprégnée par du matériau polymère réticulable ; une étape de mise en contact d'une face arrière de la cellule photovoltaïque avec la portion imprégnée, la face arrière étant opposée à une face avant de la cellule photovoltaïque, ladite face avant étant en contact avec la couche d'adhésion au sein de l'empilement,
   et l'étape de réticulation comporte la réticulation du matériau polymère réticulable imprégnant le substrat d'où il résulte l'encapsulation de la cellule photovoltaïque ;
- la viscosité du matériau polymère réticulable de la couche d'adhésion est strictement supérieure à 5 Pa.s à une température de 25°C et inférieure ou égale à 50 Pa.s à une température de 25°C ;
- la viscosité du matériau polymère réticulable de la couche d'adhésion est strictement supérieure à 5 Pa.s à une température de 25°C et inférieure ou égale à 10 Pa.s à une température de 25°C.

L'invention est aussi relative à un module photovoltaïque comportant un empilement, l'empilement comportant au moins une cellule photovoltaïque, ce module photovoltaïque est caractérisé en ce que l'empilement comporte un bicouche formé par un film d'encapsulation à base d'un matériau polymère réticulé et une couche d'adhésion à base d'un matériau polymère réticulé, la couche d'adhésion étant agencée entre ledit film d'encapsulation et la cellule photovoltaïque, la couche d'adhésion collant ledit film d'encapsulation à la cellule photovoltaïque.

Notamment, le module photovoltaïque peut comporter un substrat souple collé à une face arrière de la cellule photovoltaïque par du matériau polymère réticulé dans au moins une portion du substrat, et la cellule photovoltaïque comporte une face avant en contact avec la couche d'adhésion.

Selon un mode de réalisation particulier du module photovoltaïque, l'empilement comporte :
- un premier élément de protection,
- une couche de collage à base d'un matériau polymère réticulé, ladite couche de collage collant le film d'encapsulation au premier élément de protection,
- une couche d'adhésion additionnelle à base d'un matériau polymère réticulé,
- un film d'encapsulation additionnel à base d'un matériau polymère réticulé, le film d'encapsulation additionnel étant collé à la cellule photovoltaïque par la couche d'adhésion additionnelle,
- une couche de collage additionnelle à base d'un matériau polymère réticulé,
- un deuxième élément de protection collé au film d'encapsulation additionnel par la couche de collage additionnelle.

Avantageusement, le film d'encapsulation et le film d'encapsulation additionnel peuvent être troués de sorte que :
- les couches d'adhésion et de collage sont reliées entre elles au niveau des trous du film d'encapsulation, notamment par du matériau polymère réticulé présent dans lesdits trous,
- les couches d'adhésion et de collage additionnelles sont reliées entre elles au niveau des trous du film d'encapsulation additionnel, notamment par du matériau polymère réticulé présent dans lesdits trous.

D'autres avantages et caractéristiques relatifs à l'invention ressortiront clairement de la description détaillée qui va suivre.

### Description sommaire des dessins

L'invention sera mieux comprise à la lecture de la description détaillée qui suit, donnée uniquement à titre d'exemple non limitatif et faite en se référant aux dessins annexés et listés ci-dessous.
La figure 1 représente une vue en coupe d'un module photovoltaïque formé par la mise en œuvre d'un procédé de fabrication d'un module photovoltaïque selon un premier mode de réalisation de l'invention.
La figure 2 représente une vue en coupe d'un module photovoltaïque formé par la mise en œuvre du procédé de fabrication du module photovoltaïque selon un deuxième mode de réalisation de l'invention.
La figure 3 représente une vue en coupe du module photovoltaïque formé par la mise en œuvre d'un perfectionnement du procédé de fabrication du module photovoltaïque selon le deuxième mode de réalisation.
La figure 4 illustre, selon une vue en coupe, une étape du procédé de fabrication.
La figure 5 illustre, selon une vue en coupe, une étape du procédé de fabrication.
La figure 6 illustre, selon une vue en coupe, une étape du procédé de fabrication.
La figure 7 illustre, selon une vue en coupe, une étape du procédé de fabrication.
La figure 8 illustre, selon une vue en coupe, une étape du procédé de fabrication.
La figure 9 illustre, selon une vue en coupe, une étape du procédé de fabrication.
La figure 10 illustre, selon une vue en coupe, une étape du procédé de fabrication.
La figure 11 illustre, selon une vue en coupe, une étape du procédé de fabrication.
La figure 12 illustre, selon une vue en coupe, un perfectionnement du procédé de fabrication.
La figure 13 illustre, selon une vue en coupe, un module photovoltaïque obtenu au terme du procédé de fabrication selon une réalisation du deuxième mode de réalisation.
La figure 14 illustre, selon une vue en coupe, l'ajout d'un support à l'empilement représenté en figure 3.
La figure 15 illustre, selon une vue en coupe, un module photovoltaïque obtenu par la mise en œuvre d'un troisième mode de réalisation du procédé de fabrication.
La figure 16 illustre, selon une vue en coupe, une étape du troisième mode de réalisation du procédé de fabrication.
La figure 17 illustre, selon une vue en coupe, une étape du troisième mode de réalisation du procédé de fabrication.
La figure 18 illustre, selon une vue en coupe, une étape du troisième mode de réalisation du procédé de fabrication.
La figure 19 illustre, selon une vue en coupe, une étape du troisième mode de réalisation du procédé de fabrication.
La figure 20 illustre, selon une vue en coupe, une étape du troisième mode de réalisation du procédé de fabrication.

Dans ces figures, les mêmes références sont utilisées pour désigner les mêmes éléments.

### Description détaillée

Dans la présente description, une valeur comprise entre deux bornes s'entend bornes incluses.

Classiquement, une cellule photovoltaïque présente deux faces opposées respectivement appelées face avant et face arrière. La face avant de la cellule photovoltaïque est une face dite « active », c'est-à-dire configurée pour recevoir un rayonnement, notamment solaire, à convertir en énergie électrique. Typiquement la cellule photovoltaïque du module photovoltaïque décrit ci-après peut présenter une épaisseur comprise entre 10 micromètres et 300 micromètres.

Un module photovoltaïque au sens de la présente description comporte au moins une cellule photovoltaïque encapsulée pour la protéger.

Dans la présente description, le terme « transparent » signifie transparent au rayonnement, notamment solaire, que la cellule photovoltaïque peut exploiter pour générer de l'énergie électrique. La transparence est donc adaptée en fonction de l'application et est suffisante pour autoriser une conversion photovoltaïque par la cellule photovoltaïque. Notamment, chaque film d'encapsulation (additionnel ou non) décrit ci-après est transparent, et chaque couche d'adhésion (additionnelle ou non) ou de collage (additionnelle ou non) décrite ci-après dont le matériau polymère est dans son état réticulé est transparente, le cas échéant pour permettre au rayonnement, notamment solaire, d'atteindre la face avant de la cellule photovoltaïque.

Dans la présente description lorsqu'un élément est déformable, une déformation de cet élément peut être réalisée au cours d'une lamination qui sera décrite plus en détail ci-après.

Dans la présente description, lorsqu'un élément est rigide, on entend qu'il ne se déforme pas, notamment au cours d'une lamination mise en œuvre au cours du procédé de fabrication.

Dans la présente description, par « à base de », on entend notamment « comporte au moins majoritairement ». En ce sens, dans le cadre « d'un élément à base d'un matériau », « à base de » peut aussi désigner « est constitué par », et dans ce cas le matériau concerné est le seul à entrer dans la composition dudit élément.

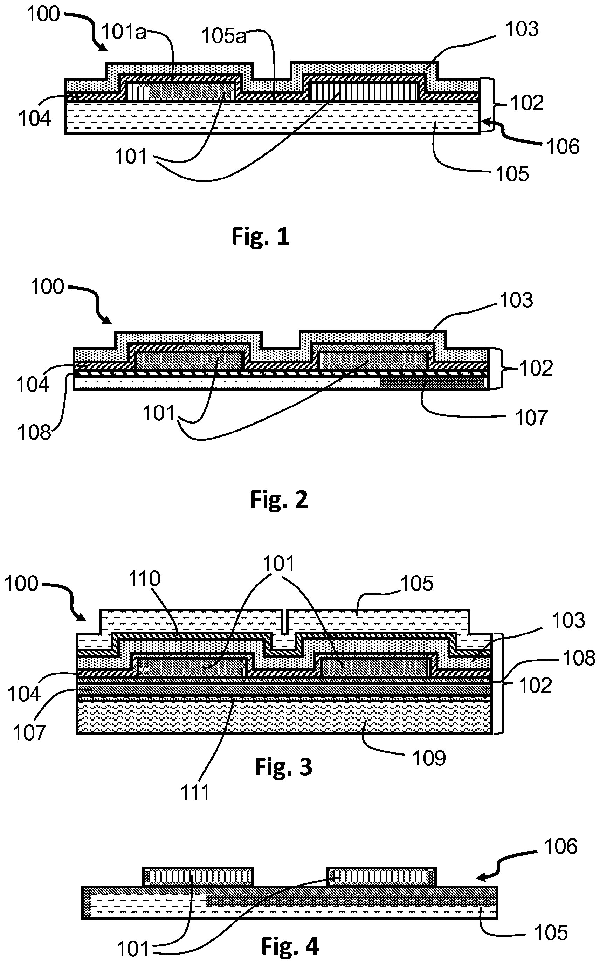

L'invention est relative à un procédé de fabrication d'un module photovoltaïque 100 comportant au moins une cellule photovoltaïque 101. Des étapes d'un tel procédé de fabrication, ou le cas échéant des produits obtenus par ce procédé de fabrication, selon différentes réalisations sont représentés en figures 1 à 20.

Par « au moins une cellule photovoltaïque 101 », il est entendu par la suite que si le module photovoltaïque 100 en comporte plusieurs, tout ce qui s'applique à la cellule photovoltaïque 101 peut s'appliquer à chacune des cellules photovoltaïques 101. Par exemple, les figures 1 à 4, 6 à 9, 11 à 16 et 19 à 20 montrent deux cellules photovoltaïques 101. En ce sens, par la suite « la cellule photovoltaïque 101 », fait référence à « ladite au moins une cellule photovoltaïque 101 ».

De manière générale, le procédé de fabrication du module photovoltaïque 101 comporte une étape d'encapsulation de la cellule photovoltaïque 101. Cette étape d'encapsulation comporte la formation d'un empilement 102 (notamment visible en figures 1 à 3, 6, 8, 11 à 16, 19 et 20) en vue d'encapsuler la cellule photovoltaïque 101. La formation de l'empilement 102 est telle que ledit empilement 102 comporte :
- la cellule photovoltaïque 101 aussi dite « cellule photovoltaïque 101 à encapsuler »,
- un film 103 d'encapsulation à base d'un matériau polymère réticulé au moins à son point de gel, le film 103 d'encapsulation peut être constitué du matériau polymère réticulé,
- une couche 104 d'adhésion à base d'un matériau polymère réticulable, la couche 104 d'adhésion étant destinée à coller le film 103 d'encapsulation à la cellule photovoltaïque 101, de préférence la couche 104 d'adhésion est constituée par le matériau polymère réticulable.

Le film 103 d'encapsulation est aussi appelé film d'encapsulation pour cellule photovoltaïque 101. Le film 103 d'encapsulation est préférentiellement déformable. Notamment, au sein de l'empilement 102, la couche 104 d'adhésion est en contact, d'une part, avec le film 103 d'encapsulation et, d'autre part, avec la cellule photovoltaïque 101 et plus particulièrement avec l'une des deux faces (avant ou arrière) de la cellule photovoltaïque 101.

Comme évoqué ci-dessus, l'empilement 102 peut comporter plusieurs cellules photovoltaïques 101. En ce sens, lorsque l'empilement 102 comporte une pluralité de cellules photovoltaïques 101, tout ce qui s'applique à la cellule photovoltaïque 101 peut s'appliquer à chacune des cellules photovoltaïques, et ces cellules photovoltaïques 101 sont dites « coplanaires », de préférence interconnectées entre elles (c'est-à-dire reliées électriquement), et ces cellules photovoltaïques sont notamment collées au film 103 d'encapsulation par la même couche 104 d'adhésion.

Comme cela sera décrit plus en détails ci-après, l'empilement 102 peut aussi comporter un film d'encapsulation additionnel, une couche d'adhésion additionnelle, et le cas échéant une couche de collage et une couche de collage additionnelle. Notamment, ce qui s'applique à aux caractéristiques de la couche d'adhésion (par exemple dimensions, matériau, propriétés) peut s'appliquer à la couche d'adhésion additionnelle, à la couche de collage et à la couche de collage additionnelle, et ce qui s'applique aux caractéristiques du film d'encapsulation (par exemple dimensions, matériau, propriétés) peut s'appliquer au film d'encapsulation additionnel.

Lorsque les éléments présents au sein de l'empilement 102 présentent une épaisseur, on entend que cette épaisseur est mesurée selon, c'est-à-dire parallèlement à, la direction d'empilement de ces éléments.

Par ailleurs, le procédé de fabrication comporte une étape de réticulation comportant la réticulation du matériau polymère réticulable de la couche 104 d'adhésion afin d'assurer le collage du film 103 d'encapsulation à la cellule photovoltaïque 101, notamment à la face avant ou arrière de la cellule photovoltaïque 101. Autrement dit, lorsque la matériau polymère réticulable de la couche 104 d'adhésion passe à son état réticulé, il assure le collage évoqué ci-dessus. Ceci participe à former une enveloppe d'encapsulation de la cellule photovoltaïque 101.

Un tel procédé de fabrication présente l'avantage d'utiliser un film 103 d'encapsulation manipulable pour réaliser l'encapsulation. Autrement dit, le film 103 d'encapsulation utilisé au sein de l'empilement 102 est un film solide autoportant. Par ailleurs, le film 103 d'encapsulation présente une épaisseur qui peut être calibrée de sorte à assurer une épaisseur minimum d'encapsulant au terme de l'encapsulation de la cellule photovoltaïque 101. Un autre avantage est que la couche 104 d'adhésion présente une épaisseur limitée du fait qu'elle n'est pas destinée à assurer à elle seule l'encapsulation de la cellule photovoltaïque 101. La limitation de cette épaisseur permet de limiter la formation de bulles de gaz, notamment d'air, dans l'encapsulant comportant à terme le film 103 d'encapsulation et la couche 104 d'adhésion dont le matériau polymère réticulable est à l'état réticulé. La limitation de cette épaisseur permet aussi d'éviter au matériau polymère réticulable de la couche 104 d'adhésion de fluer sur les bords de l'empilement 102 au cours de sa réticulation.

Par « matériau polymère réticulable », on entend dans la présente description « un matériau polymère apte à être réticulé » dont l'état peut passer à un état réticulé, par exemple lors d'une étape de lamination de l'empilement 102 comme cela est décrit ci-après.

De manière générale, par « film d'encapsulation à base d'un matériau polymère réticulé au moins à son point de gel », il est entendu que le film d'encapsulation est à l'état solide (il est alors aisément manipulable) et est notamment infusible. Le film 103 d'encapsulation se comporte donc comme un élément monolithique manipulable.

Le point de gel d'un matériau polymère se caractérise par une augmentation brutale de la viscosité complexe de ce matériau polymère et du module de cisaillement complexe de ce matériau polymère. Au point de gel et au-delà, un réseau tridimensionnel se forme et les chaînes de ce matériau polymère ne peuvent plus glisser les unes sur les autres. De préférence, le matériau polymère du film 103 d'encapsulation est réticulé au-delà de son point de gel, ceci le rendant moins fragile qu'à son point de gel.

Un film d'encapsulation au sens de la présente description comporte préférentiellement des première et deuxième faces opposées reliées entre elles à leur périphérie par un bord du film.

Dans la présente description, un matériau polymère réticulable présente notamment un degré de réticulation strictement inférieur au point de gel de ce matériau polymère. Notamment, le matériau polymère réticulable est à l'état liquide. Par « matériau à l'état liquide », il est entendu que le matériau a tendance à couler en raison de la faible cohésion des molécules qui le compose. Notamment, l'état liquide du matériau polymère réticulable est tel que ce matériau polymère réticulable présente une viscosité préférentiellement comprise entre 1 Pa.s et 50 Pa.s à une température de 25 °C. Dans la présente description, les valeurs de viscosités sont données à la pression atmosphérique. Une telle viscosité permet d'obtenir d'une couche d'adhésion fine, par exemple d'épaisseur comprise entre 10 µm et 100 µm tout particulièrement adaptée pour coller le film d'encapsulation en limitant la formation de bulles de gaz. En particulier, la viscosité du matériau polymère réticulable, de préférence ceci pouvant s'appliquer à la viscosité du matériau polymère réticulable de la couche d'adhésion et/ou à la viscosité du matériau polymère réticulable de la couche d'adhésion additionnelle, peut être strictement supérieure à 5 Pa.s à une température de 25°C et être inférieure ou égale à 50 Pa.s à une température de 25°C, de préférence cette viscosité est strictement supérieure à 5 Pa.s à une température de 25°C et est inférieure ou égale à 10 Pa.s à une température de 25°C.

De préférence, dans la présente description tout matériau polymère évoqué, qu'il soit réticulé, réticulé au moins à son point de gel ou réticulable, peut être choisi parmi la famille des silicones aussi appelée famille des polysiloxanes. Par la suite, le silicone est défini par un polymère choisi parmi la famille des silicones.

Par ailleurs, chaque élément à base d'un matériau polymère réticulé, réticulé au moins à son point de gel ou réticulable peut aussi comporter des additifs pour améliorer certaines propriétés comme la résistance aux radiations ou la filtration de certaines longueurs d'onde.

Le matériau polymère du film d'encapsulation et le matériau polymère de la couche d'adhésion peuvent être identiques ou non lorsqu'ils sont à l'état réticulé.

Le silicone peut avantageusement être utilisé pour encapsuler la cellule photovoltaïque 101. Une telle encapsulation de la cellule photovoltaïque 101 est avantageuse car le silicone peut être transparent, être isolant électriquement, et présenter une stabilité environnementale et thermique (c'est-à-dire pas ou peu de dégradations liées à l'humidité, à l'oxygène ou aux acides à des températures variant entre -200 °C et 200 °C). Par ailleurs, le silicone peut améliorer la durée de vie du module photovoltaïque par rapport à un encapsulant en EVA. Le silicone évite la formation d'acide acétique, contrairement à l'EVA. Le silicone présente une meilleure stabilité aux rayonnements ultraviolets. La chimie du silicone est suffisamment flexible pour ajuster avec précision les propriétés physico-chimiques (indice de réfraction, viscosité, dureté, résistance à la traction) de l'encapsulant tout en permettant une production en masse. En raison du faible module de Young du silicone et de la faible température de transition vitreuse (par exemple de -50°C) du silicone, les propriétés mécaniques du silicone réticulé restent constantes sur une large gamme de températures. Avec le silicone, il est possible d'encapsuler une ou plusieurs cellules photovoltaïques pour une application spatiale à une température pouvant varier entre -65° C et +200°C et utilisables jusqu'à -200°C.

L'encapsulation d'une cellule photovoltaïque 101 avec du silicone est généralement difficile à mettre en œuvre car elle est réalisée par voie liquide générant la présence de bulles de gaz (notamment d'air) pouvant entraîner la destruction du module photovoltaïque 100 dans le cadre de l'application spatiale. L'utilisation du film 103 d'encapsulation et de la couche 104 d'adhésion tels que décrits permet de limiter la quantité matériau polymère réticulable à l'état liquide utilisé lors de l'encapsulation. Il en résulte aussi que l'encapsulation de la cellule photovoltaïque 101 est compatible avec des méthodes de lamination tout en limitant le fluage du matériau polymère réticulable lors de la lamination.

En particulier, tout matériau polymère réticulable visé dans la présente description peut comporter, notamment être constitué de, deux composants A et B. Le composant A est une base, par exemple de type PDMS (pour polydiméthylsiloxane). Le composant B contient un agent vulcanisant, comme par exemple le polysiloxane, et un catalyseur pour permettre aux chaînes de polymère de se ramifier pour former un réseau tridimensionnel de sorte que le matériau polymère réticulable puisse, au terme de sa réticulation, former une couche correspondante en matériau solide et infusible.

Le matériau polymère réticulable utilisé dans le cadre du présent procédé de fabrication peut être choisi parmi : Sylgard^{®} 184 de l'entreprise Dow Corning, Dow Corning ^{®} 93-500, Siltech ^{®} CR 12-63, Siltech ^{®} CR 13-46, Elastosil ^{®} RT 625 de l'entreprise Wacker, MAPSIL ^{®} 213 de l'entreprise MAP COATING, MAPSIL ^{®} 213B de l'entreprise MAP COATING, et MAPSIL ^{®} QS1123 de l'entreprise MAP COATING. Par ailleurs, le film 103 d'encapsulation peut avoir été obtenu par réticulation d'un tel matériau polymère réticulable au moins à son point de gel.

Alternativement, le matériau polymère réticulable ou réticulé au moins à son point de gel peut être à base de polymères acryliques. La chimie des acryliques sera adaptée en fonction des propriétés souhaitées. Dans ce cas, le film d'encapsulation aura été obtenu préférentiellement à partir de la même formulation que la résine acrylique formant le matériau polymère réticulable. Pour que le film d'encapsulation réticulé ait des propriétés élastiques semblables à celles des silicones, sa température de transition vitreuse devra être, de préférence, inférieure à la température ambiante, et si ce n'est pas le cas, il devra être au moins suffisamment élastique et déformable à la température de la lamination qui pourra être effectuée pour former le module photovoltaïque. De plus, une faible température de transition vitreuse du polymère acrylique formant le film d'encapsulation améliorera la conservation des propriétés mécaniques à très faible température, ce qui est indispensable pour des applications spatiales. La température de transition vitreuse (Tg) dépend fortement du monomère utilisé. Pour obtenir des polymères acryliques à faibles Tg, des monomères de base comme le 2-Ethyl hexyl acrylate, le n-Butyl acrylate ou l'Iso-octyl acrylate peuvent être, par exemple, utilisés.

De préférence, la couche 104 d'adhésion peut présenter une épaisseur comprise entre 10 µm et 100 µm. Cette gamme d'épaisseur est tout particulièrement adaptée pour coller un film 103 d'encapsulation d'épaisseur strictement supérieure à celle de la couche 104 d'adhésion tout en limitant l'apparition de bulles de gaz et le fluage du matériau polymère réticulable hors du module photovoltaïque 100 au cours de la réticulation, notamment lorsqu'elle est réalisée par une lamination.

Le procédé de fabrication peut comporter une étape de formation du film 103 d'encapsulation (ceci étant aussi valable pour le film d'encapsulation additionnel décrit ci-après), par exemple par dépôt de matériau polymère réticulable sous forme liquide notamment sur un film support détachable en polymère (aussi appelé liner) comme par exemple du PET (polytéréphtalate d'éthylène). Un tel dépôt sur le film support peut être réalisé selon un procédé d'enduction, ou de vaporisation, ou de raclage (par exemple au « doctor blade » en langue anglaise). Ensuite, une étape de réticulation du matériau polymère réticulable déposé est réalisée pour former un film solide par exemple d'élastomère silicone avant de retirer le film support détachable d'où il résulte l'obtention du film 103 d'encapsulation.

De préférence, tout matériau polymère réticulé au sein de l'empilement 102 a été obtenu par l'utilisation du même matériau polymère réticulable pour homogénéiser les propriétés physico-chimiques de l'enveloppe d'encapsulation de la cellule photovoltaïque 101.

De préférence, l'utilisation d'un film 103 d'encapsulation en matériau polymère réticulé au moins à son point de gel mais pas totalement permet d'améliorer la liaison entre la couche d'adhésion 104 et le film 103 d'encapsulation au terme de la réticulation du matériau polymère réticulable et de la réticulation du matériau polymère du film 103 d'encapsulation.

De préférence, le film 103 d'encapsulation peut présenter une épaisseur comprise entre 25 µm et 400 µm. Cette gamme d'épaisseur est tout particulièrement adaptée pour une encapsulation de cellule photovoltaïque 101, et permet au film d'encapsulation 103 d'être manipulable.

De préférence, le film 103 d'encapsulation est souple. Sa souplesse lui permet de se déformer, notamment lors de la formation de l'empilement 102, ou au cours d'une étape de lamination de l'empilement 102.

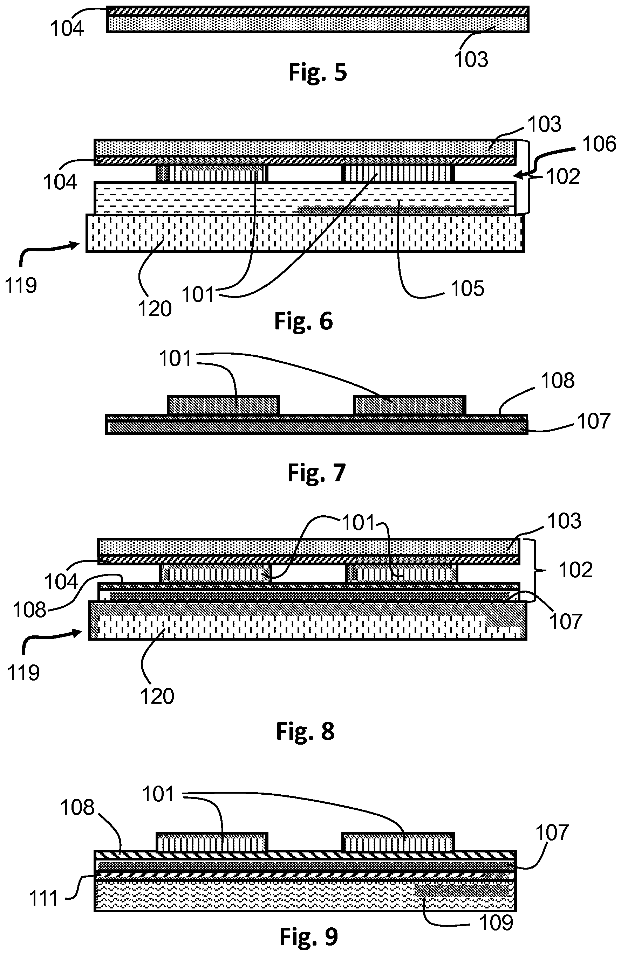

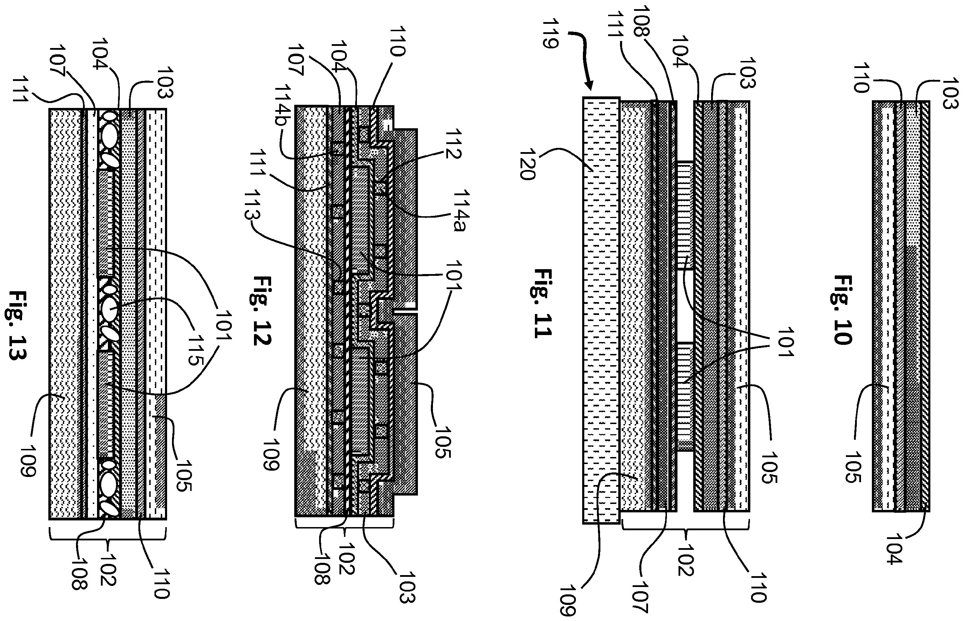

Il résulte de ce qui a été évoqué ci-dessus qu'une lamination peut aussi être mise en œuvre dans le cadre du présent procédé de fabrication pour permettre d'éliminer le plus d'air possible présent dans l'empilement 102, de réticuler tout matériau polymère réticulable présent au sein de l'empilement 102, et d'assurer un compactage adéquat du module photovoltaïque 100. En ce sens, le procédé de fabrication, notamment son étape d'encapsulation, comporte avantageusement une étape de lamination de l'empilement 102 mettant en œuvre l'étape de réticulation. De préférence, cette étape de lamination est telle que l'empilement 102 est laminé sous vide et à une température adaptée pour obtenir la réticulation souhaitée de tout matériau polymère réticulable présent au sein de l'empilement 102. Bien entendu, la durée de lamination sous vide et la température appliquée sont adaptées au matériau polymère à réticuler. De manière générale, l'étape de lamination peut être réalisée sous vide, par exemple à 1 mbar, à chaud par exemple entre 60°C et 150°C, et pendant une durée adaptée à la réticulation de chaque matériau polymère réticulable présent au sein de l'empilement 102, par exemple cette durée est comprise entre 10 min et 240 min. Par exemple, pour réticuler le Sylgard ^{®} 184, l'étape de lamination peut être réalisée en plaçant l'empilement 102 sous vide de 1mbar, à 140°C et cela pendant au moins 15 minutes. A titre d'exemple, les figures 6, 8 et 11 montrent un laminateur 119 ayant une table 120 sur laquelle l'empilement 102 est positionné, l'étape de lamination permet de passer de la figure de la figure 6 à la figure 1, de la figure 8 à la figure 2, de la figure 11 à la figure 3, notamment en entraînant la déformation du film 103 d'encapsulation.

De manière générale, la température utilisée pour laminer l'empilement 102 peut être adaptée en fonction des différents matériaux présents dans l'empilement 102 en tenant compte de leur coefficient d'expansion thermique pour éviter la génération de courbures indésirables au sein du module photovoltaïque 100.

De préférence, le procédé de fabrication comporte une étape de formation de la couche 104 d'adhésion sur le film 103 d'encapsulation (figures 5 et 10) avant de mettre en contact la couche 104 d'adhésion avec la cellule photovoltaïque 101 (figures 6, 8, 11 et 19). Notamment, la couche 104 d'adhésion est formée sur la première face du film 103 d'encapsulation, de préférence de sorte à couvrir entièrement cette première face. La formation de la couche 104 d'adhésion sur le film 103 d'encapsulation présente l'avantage de rendre la couche 104 d'adhésion apte à être manipulée avec le film 103 d'encapsulation qui en forme un support, il en résulte que l'encapsulation est plus aisée à mettre en œuvre.

Selon un premier mode de réalisation illustré en figure 1, au terme du procédé de fabrication, la cellule photovoltaïque 101 est solidaire d'un élément 105 de protection, par exemple un panneau transparent. La cellule photovoltaïque 101 est encapsulée contre cet élément 105 de protection par le film 103 d'encapsulation collé à la cellule photovoltaïque 101 et à l'élément de protection 105 grâce à la couche 104 d'adhésion dont le matériau polymère est dans son état réticulé. Pour favoriser l'accroche de la couche 104 d'adhésion, au cours de sa réticulation, à la cellule photovoltaïque 101 et à l'élément de protection 105, la face 105a de l'élément de protection 105 et la face 101a de la cellule photovoltaïque 101 en contact avec la couche 104 d'adhésion peuvent être formées chacune par un primaire d'accroche adapté. En particulier, ici le procédé de fabrication comporte : une étape de fourniture d'une partie 106 de module photovoltaïque comportant l'élément 105 de protection surmonté d'au moins une cellule photovoltaïque 101 (figure 4) ; une étape de dépôt de la couche 104 d'adhésion sur la première face du film 103 d'encapsulation (figure 5) ; une étape de mise en contact de la couche 104 d'adhésion avec une face de la cellule photovoltaïque 101 opposée à l'élément 105 de protection (figure 6) ; une étape de lamination de l'empilement 102 comportant alors la partie 106 du module photovoltaïque de sorte à déformer la couche 104 d'adhésion et le film 103 d'encapsulation pour épouser le relief d'une face de la partie 106 du module photovoltaïque comportant la cellule photovoltaïque 101 et mettre en œuvre la réticulation de la couche 104 d'adhésion. Ce premier mode de réalisation permet de fabriquer aisément un module photovoltaïque 100 en encapsulant directement la cellule photovoltaïque 101 sur l'élément 105 de protection qui la porte. Ici, la face avant de la cellule photovoltaïque 101 peut être orientée vers l'élément 105 de protection. Selon ce premier mode de réalisation, le film 103 d'encapsulation peut comporter des additifs pour apporter une protection suffisante pour l'application souhaitée (résistance aux radiations ou filtration de certaines longueurs d'onde).

Selon un deuxième mode de réalisation, notamment tel qu'illustré en figure 2 et 3, la formation de l'empilement 102 est telle que l'empilement 102 comporte une première partie comportant le film 103 d'encapsulation et la couche 104 d'adhésion destinée coller ce film 103 d'encapsulation à la cellule photovoltaïque 101. L'empilement 102 comporte en outre une deuxième partie comportant un film 107 d'encapsulation additionnel à base d'un matériau polymère réticulé au moins à son point de gel et une couche 108 d'adhésion additionnelle à base d'un matériau polymère réticulable destinée à coller le film 107 d'encapsulation additionnel de la deuxième partie à la cellule photovoltaïque 101. La couche 108 d'adhésion additionnelle est notamment formée sur une face du film 107 d'encapsulation additionnel. Par ailleurs, l'empilement 102 comporte la cellule photovoltaïque 101 interposée entre les première et deuxième parties de l'empilement 102. Notamment, la cellule photovoltaïque 101 est interposée entre, et en contact avec, la couche 104 d'adhésion et la couche 108 d'adhésion additionnelle, la face avant de la cellule photovoltaïque 101 étant en contact avec la couche 104 d'adhésion ou la couche 108 d'adhésion additionnelle. Autrement dit, l'empilement 102 peut comporter successivement le film 103 d'encapsulation, la couche 104 d'adhésion, la cellule photovoltaïque 101, la couche 108 d'adhésion additionnelle, et le film 107 d'encapsulation additionnel. Ici l'étape de réticulation comporte la réticulation du matériau polymère réticulable de la couche 108 d'adhésion additionnelle, notamment simultanément à la réticulation du matériau polymère réticulable de la couche 104 d'adhésion. Par ailleurs, il résulte de l'étape de réticulation l'encapsulation de la cellule photovoltaïque 101 entre le film 103 d'encapsulation appartenant à la première partie et le film 107 d'encapsulation additionnel appartenant à la deuxième partie. De préférence, la couche 104 d'adhésion et la couche 108 d'adhésion 108 additionnelle permettant de coller respectivement le film 103 d'encapsulation et le film 107 d'encapsulation additionnel à la cellule photovoltaïque 101 sont mises en contact entre elles à la périphérie de la cellule photovoltaïque 101, par exemple grâce à la lamination de l'empilement 102, pour permettre la formation d'une enveloppe d'encapsulation de la cellule photovoltaïque 101. Autrement dit, la couche 104 d'adhésion et la couche 108 d'adhésion 108 additionnelle permettent aussi de coller le film 103 d'encapsulation et le film 107 d'encapsulation additionnel entre eux. L'utilisation du film 103 d'encapsulation et du film 107 d'encapsulation additionnel permet d'ajuster l'épaisseur d'encapsulant des deux côtés de la cellule photovoltaïque 101 en vue de limiter cette épaisseur pour des raisons de poids du module photovoltaïque 100 et de transparence de l'encapsulant ou en vue de choisir une épaisseur adaptée pour limiter les contraintes au sein du module photovoltaïque 100. Ici, au moins la partie (première partie ou deuxième partie) de l'empilement 102, vers laquelle la face avant de la cellule photovoltaïque 101 est orientée, est transparente, notamment après l'étape de réticulation. Bien entendu, après l'étape de réticulation, les première et deuxième parties de l'empilement 102 peuvent être transparentes. Selon ce deuxième mode de réalisation, un élément de protection peut être collé au film 103 d'encapsulation ou au film 107 d'encapsulation additionnel à sa face opposée à la cellule photovoltaïque 101.

Afin d'optimiser le procédé de fabrication dans le cadre du deuxième mode de réalisation, les première et deuxième parties de l'empilement 102 peuvent être formées séparément (figures 5 et 7) avant de les associer avec interposition de la cellule photovoltaïque 101 (figure 8). En ce sens, la formation de l'empilement 102 peut comporter : une étape de formation de la première partie ; une étape de formation de la deuxième partie ; une étape d'association de la deuxième partie de l'empilement 102 à la deuxième partie de l'empilement 102 avec interposition de la cellule photovoltaïque 101 alors en contact avec la couche 104 d'adhésion et avec la couche 108 d'adhésion additionnelle ; une étape de mise en contact de la couche 104 d'adhésion avec la couche 108 d'adhésion additionnelle, ceci permettant de former l'enveloppe d'encapsulation. Notamment, la mise en contact de la couche 104 d'adhésion avec la couche 108 d'adhésion additionnelle est assurée par l'étape de lamination de l'empilement 102. Ici, l'étape de réticulation permet de réticuler le matériau polymère réticulable de la couche 104 d'adhésion et le matériau polymère réticulable de la couche d'adhésion 108 additionnelle pour encapsuler la cellule photovoltaïque 101.

En fonction des besoins, il peut être nécessaire d'encapsuler la cellule photovoltaïque 101 entre un premier élément de protection 105 et un deuxième élément de protection 109 (figure 3). De préférence, l'un des premier et deuxième éléments de protection 105, 109 forme une face avant du module photovoltaïque 100 vers laquelle la face avant de la cellule photovoltaïque 101 est orientée, et l'autre des premier et deuxième éléments de protection 105, 109 forme un élément de protection placé du côté arrière, ou formant une face arrière, du module photovoltaïque 100. Il existe donc une besoin de coller les premier et deuxième éléments 105, 109 de protection respectivement au film 103 d'encapsulation et au film 107 d'encapsulation, de préférence tout en limitant la formation de bulles de gaz lors de la fabrication. Ceci peut avantageusement être mis en œuvre à l'aide d'une couche 110 de collage et d'une couche 111 de collage additionnelle, notamment chacune à base d'un matériau polymère réticulable de préférence identique à celui de la couche 104 d'adhésion et à celui de la couche 108 d'adhésion additionnelle. Ainsi, pour répondre à ce besoin, la formation de l'empilement 102 peut être telle que l'empilement 102 comporte des premier et deuxième éléments 105, 109 de protection entre lesquels sont agencées les première et deuxième parties de l'empilement 102. La première partie de l'empilement 102 comporte alors une couche 110 de collage à base d'un matériau polymère réticulable destinée à coller le film 103 d'encapsulation, appartenant à la première partie, au premier élément 105 de protection. La deuxième partie comporte alors une couche 111 de collage additionnelle à base d'un matériau polymère réticulable destinée à coller le film 107 d'encapsulation additionnel, appartenant à la deuxième partie, au deuxième élément 109 de protection. Le matériau polymère réticulable de chacune des couches 104, 108, 110, 111 est réticulé au cours de l'étape de réticulation. Autrement dit, l'étape de réticulation comporte la réticulation du matériau polymère réticulable de la couche 110 de collage et du matériau polymère réticulable de la couche 111 de collage additionnelle, notamment simultanément à la réticulation du matériau polymère réticulable de la couche 104 d'adhésion et à la réticulation du matériau polymère réticulable de la couche 108 d'adhésion additionnelle, de telle sorte qu'il résulte de l'étape de réticulation la formation de l'enveloppe d'encapsulation de la cellule photovoltaïque 101 collée aux premier et deuxième éléments 105, 109 de protection.

Notamment, l'étape de formation de la première partie peut être telle que la première partie est formée sur le premier élément 105 de protection (figure 10), et l'étape de formation de la deuxième partie peut être telle que la deuxième partie est formée sur le deuxième élément 109 de protection (figure 9) avant d'associer (figure 11) les première et deuxième parties avec interposition de la cellule photovoltaïque 101 pour obtenir l'empilement 102. Ceci est simple à mettre en œuvre et permet de limiter le risque de casse de la cellule photovoltaïque 101 en la plaçant dans l'empilement au dernier moment

Pour former la première partie de l'empilement 102 sur le premier élément de protection 105, le procédé de fabrication comporte préférentiellement et notamment successivement (figure 10) : une étape de dépôt de la couche 110 de collage, notamment sur une couche de primaire d'accroché du premier élément 105 de protection pour favoriser l'accroche de la couche 110 de collage à ce premier élément de protection 105 lors de la réticulation de son matériau polymère réticulable ; une étape de positionnement du film 103 d'encapsulation sur la couche 110 de collage ; une étape de dépôt de la couche 104 d'adhésion sur le film 103 d'encapsulation.

Pour former la deuxième partie de l'empilement 102 sur le deuxième élément 109 de protection, le procédé de fabrication comporte préférentiellement et notamment successivement (figure 9) : une étape de dépôt de la couche 111 de collage additionnelle, notamment sur une couche de primaire d'accroché du deuxième élément 109 de protection pour favoriser l'accroche de la couche 111 de collage additionnelle à ce deuxième élément de protection 109 lors de la réticulation de son matériau polymère réticulable ; une étape de positionnement du film 107 d'encapsulation additionnel sur la couche 111 de collage additionnelle; une étape de dépôt de la couche 108 d'adhésion additionnelle sur le film 107 d'encapsulation additionnel.

La cellule photovoltaïque 101, préférentiellement enduite d'un primaire d'accroché pour favoriser son adhésion avec la couche 108 d'adhésion additionnelle et avec la couche 104 d'adhésion, peut être mise en contact avec la couche 108 d'adhésion additionnelle, ou la couche 104 d'adhésion, avant d'associer les deux parties de l'empilement. En figure 9, la cellule photovoltaïque 101 est positionnée sur la couche 108 d'adhésion additionnelle avant d'associer les première et deuxième parties de l'empilement 102 à la manière de ce qui est visible en figure 11 : ceci est préféré pour éviter de faire face à un problème de maintien de la cellule sur une partie de l'empilement à retourner sur l'autre.

De préférence, l'élément de protection formant une face avant du module photovoltaïque, par exemple le deuxième élément 109 de protection, est transparent. Un tel élément de protection peut comporter un panneau de verre, ou de polymère transparent tel que du polyimide incolore, ou de PET (polytéréphtalate d'éthylène comme par exemple du MYLAR^{®}), ou de PEN (polynaphtalate d'éthylène), ou de copolymère d'éthylène et de chlorotrifluoroéthylène (par exemple du HALAR^{®}), ou de fluoroéthylène propylène (FEP), ou de polyétheréthercétone (PEEK). De préférence, le panneau présente une face sur laquelle est formée une couche de primaire d'accroché pour favoriser l'accroche de la couche 110 de collage ou de la couche 111 de collage additionnelle correspondante lors de sa réticulation. Avant de former cette couche de primaire d'accroché sur la face du panneau, il est préférable de réaliser un traitement corona ou plasma de cette face pour optimiser l'adhésion de la couche de primaire d'accroché. Le rôle de cet élément de protection formant la face avant du module photovoltaïque 100 est de le protéger des agressions extérieures comme par exemple la grêle, l'humidité, le dioxygène dans un environnement terrestre, ou comme par exemple des débris, de l'oxygène atomique ou des radiations dans un environnement spatial.

L'élément de protection placé du côté arrière ou formant une face arrière n'est pas forcément transparent, il peut comporter un support en composite carbone associé à un nid d'abeille en aluminium pour réaliser de la dissipation thermique, une mousse, un panneau de verre, un film polymère déformable pouvant assurer une protection de type isolation électrique, ou un tissu. L'élément de protection placé du côté arrière peut être flexible ou rigide, si ce dernier est rigide alors l'élément de protection situé en face avant est flexible pour permettre la lamination de l'ensemble comportant l'empilement 102 agencé entre les premier et deuxième éléments de protection. De préférence, cet élément de protection présente une face formée par une couche en primaire d'accroché pour favoriser l'accroche d'une couche de collage additionnelle ou non correspondante. Avant de former cette couche de primaire d'accroché, il est préférable de réaliser un traitement corona ou plasma pour optimiser l'adhésion de la couche en primaire d'accroché à l'élément de protection correspondant. L'élément de protection placé du côté arrière peut servir de support mécanique et de barrière à l'humidité, au dioxygène, aux radiations, ou encore à l'oxygène atomique.

Selon un perfectionnement du deuxième mode de réalisation comprenant les premier et deuxième éléments 105, 109 de protection tel qu'illustré en figure 12, le film 103 d'encapsulation appartenant à la première partie de l'empilement 102 et le film 107 d'encapsulation additionnel appartenant à la deuxième partie de l'empilement 102 sont troués de sorte qu'au sein de l'empilement 102 : la couche 104 d'adhésion et la couche 110 de collage de la première partie de l'empilement 102 sont reliées entre elles au niveau des trous 112 du film 103 d'encapsulation appartenant à la première partie, notamment par du matériau polymère réticulable 114a présent dans lesdits trous 112 du film 103 d'encapsulation ; et la couche 108 d'adhésion additionnelle et la couche 111 de collage additionnelle de la deuxième partie de l'empilement 102 sont reliées entre elles au niveau des trous 113 du film 107 d'encapsulation additionnel appartenant la deuxième partie de l'empilement, notamment par du matériau polymère réticulable 114b présent dans lesdits trous 113 du film 107 d'encapsulation additionnel. De préférence, les trous décrits sont des trous traversant le film d'encapsulation ou le film d'encapsulation additionnel selon son épaisseur. Les trous peuvent présenter chacun un diamètre compris entre 200 µm et 2 mm. En dessous de 200 µm de diamètre, les trous auraient du mal à se remplir de matériau polymère réticulable, et au-dessus de 2 mm de diamètre, les trous nécessiteraient l'utilisation de trop de matériau polymère réticulable ce qui favorisait la formation de bulles de gaz ou l'écoulement de ce matériau polymère réticulable au cours de la lamination. De préférence, moins de 50% du volume du film 103 d'encapsulation est occupé par les trous de ce film 103 d'encapsulation pour assurer une solidité satisfaisante de ce film 103 d'encapsulation (au-delà de 50% le film correspondant serait très difficile à manipuler sans le casser), ceci s'applique de la même manière au film 107 d'encapsulation additionnel. Par « au niveau des trous », on entend qu'au sein de l'empilement 102, du matériau polymère réticulable 114a, 114b est présent dans les trous du film 103 d'encapsulation et du film 107 d'encapsulation additionnel. Le matériau polymère réticulable 114a présent dans les trous 112 peut avoir été déposé dans les trous du film 103 d'encapsulation, notamment par écoulement du fait de la gravité, au moment de la formation de la couche 104 d'adhésion sur le film 103 d'encapsulation. Le matériau polymère réticulable 114b présent dans les trous 113 peut avoir été déposé dans les trous du film d'encapsulation 107 additionnel, notamment par écoulement du fait de la gravité, au moment de la formation de la couche 108 d'adhésion additionnelle sur le film 107 d'encapsulation additionnel. L'étape de réticulation est alors telle que le matériau polymère réticulable 114a, 114b présent dans les trous 112, 113 se réticule et permet d'améliorer la cohésion de l'enveloppe d'encapsulation. En effet, ceci permet de limiter la délamination de l'enveloppe d'encapsulation au contact du film 103 d'encapsulation et au contact du film 107 d'encapsulation additionnel. Ceci est tout particulièrement intéressant lorsque le film 103 d'encapsulation, le film 107 d'encapsulation additionnel, le matériau polymère réticulé dans les trous et les matériaux polymères réticulés de la couche 104 d'adhésion, de la couche 108 d'adhésion additionnelle, de la couche 110 de collage, de la couche 111 de collage additionnelle comportent du silicone car chaque film d'encapsulation (additionnel ou non) est alors pris en sandwich et traversé en une pluralité d'endroits par un élément monolithique en silicone réticulé formé à partir de deux couches en matériau polymère réticulés agencées de part et d'autre de ce film d'encapsulation.

Si les premier et deuxième éléments de protection 105, 109 sont rigides. On retrouve généralement après l'étape de lamination (passage de la figure 11 à la figure 13) des bulles de gaz 115, notamment d'air, présentes dans l'enveloppe d'encapsulation. Ceci est notamment dû à un déficit de matière issue de la couche 104 d'adhésion et de la couche d'adhésion 108 additionnelle destinées à coller respectivement le film 103 d'encapsulation et le film 107 d'encapsulation additionnel à la cellule photovoltaïque 101. En effet, la somme des épaisseurs de la couche 104 d'adhésion, de la couche 108 d'adhésion additionnelle, de la couche 110 de collage, de la couche 111 de collage additionnelle est inférieure à l'épaisseur de la cellule photovoltaïque 101 de sorte qu'il en résulte la formation de ces bulles 115 en périphérie de la cellule photovoltaïque 101. Ainsi, il y a donc un risque d'éclatement du module photovoltaïque 100, notamment si celui-ci est placé dans un environnement où la pression est fortement différente de la pression au sein des bulles. Il existe donc un besoin de trouver une solution pour limiter la formation de telles bulles. L'augmentation de l'épaisseur des couches en matériau polymère réticulable avant lamination n'est pas une solution dans le sens où la lamination provoque un écoulement du matériau polymère réticulable en direction de l'extérieur de l'empilement 102.

En ce sens, pour éviter la formation de bulles 115 dans le cadre de l'utilisation d'un empilement 102 comportant les premier et deuxième éléments de protection 105, 109, au moins l'un des premier et deuxième éléments de protection 105, 109 est déformable de telle sorte qu'il subit une déformation au cours de l'étape de lamination. Autrement dit, le premier élément de protection 105 et/ou le deuxième élément de protection 109 sont déformables. Par exemple (figure 3 et 12), le premier élément 105 de protection est déformable et sa déformation au cours de l'étape de lamination provoque la déformation du film 103 d'encapsulation, de la couche 104 d'adhésion en contact avec ce film 103 d'encapsulation et de la couche 110 de collage en contact avec ce film 103 d'encapsulation pour limiter l'apparition de bulles. Ces déformations permettent de former une enveloppe d'encapsulation en épousant la cellule photovoltaïque 101 et en mettant en contact la couche 104 d'adhésion et la couche 108 d'adhésion additionnelle autour de la cellule photovoltaïque 101.

Notamment, dans le cadre de l'utilisation d'un laminateur 119 à table 120 de lamination plane, l'empilement 102 est positionné sur la table 120 de sorte que le premier élément 105 de protection déformable soit à distance de la table 120 (figure 11). Si les deux éléments 105, 109 de protection sont déformables le positionnement sur la table n'a pas d'importance, il suffit de placer l'un des premier et deuxième éléments 105, 109 de protection en contact contre la table 120 (cet élément de protection restera plat) et l'autre des premier et deuxième élément de protection à distance de la table 120 (cet élément de protection se déformera lors de la lamination).

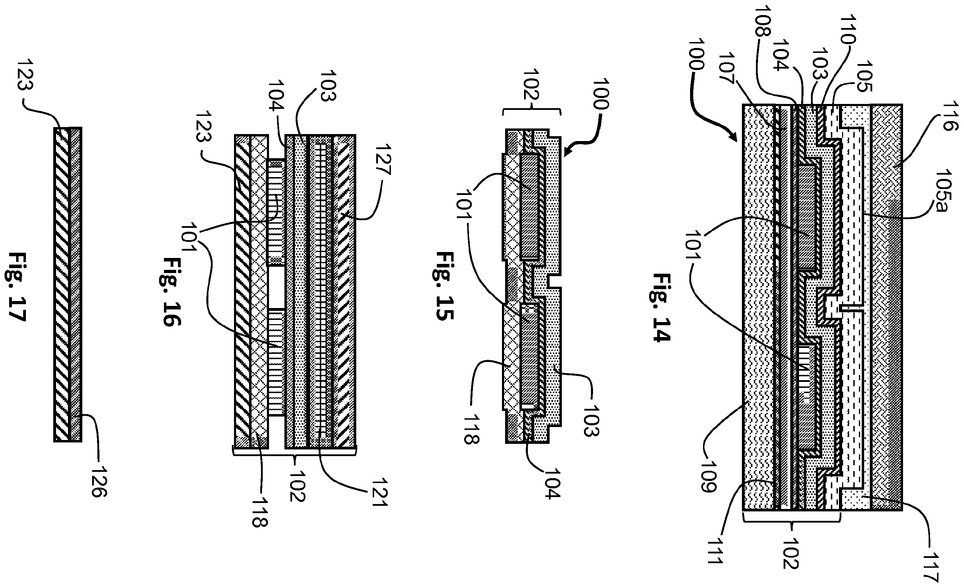

Suivant la destination d'utilisation du module photovoltaïque 100, ce dernier peut nécessiter d'être rigide du côté de l'élément de protection déformé, notamment lorsque ce dernier est situé du côté de la face arrière du module photovoltaïque 100. Dans ce cas, comme illustré en figure 14, le procédé de fabrication peut comporter, après l'étape de lamination, une étape de collage d'un support 116 (aussi appelé support composite) sur l'élément de protection déformé, c'est-à-dire sur le premier élément de protection déformé ou sur le deuxième élément de protection déformé (notamment le premier l'élément 105 de protection). Le support 116 peut être collé, sur une face 105a du premier élément 105 de protection opposée à la cellule photovoltaïque 101, à l'aide d'un adhésif 117, comme par exemple une colle thermoplastique (par exemple une colle époxy comme le Redux^{®} 312 de l'entreprise Hexcel), ceci étant tout particulièrement adapté une application spatiale du module photovoltaïque 100. Le support 116 peut aussi être collé à l'aide d'un adhésif 117 à base de ionomère ou d'EVA, ceci étant tout particulièrement adapté une application terrestre du module photovoltaïque 100. De préférence, pour éviter la présence de cavités, et donc de bulles de gaz, au sein du module photovoltaïque 100, le matériau utilisé pour permettre l'adhérence du support 116 au premier élément 105 de protection déformé présente, une fois interposé entre le support 116 et le premier élément de protection 105, une épaisseur permettant de combler toute cavité de la face du premier élément de protection 105 à laquelle le support 116 doit être collé. Selon les besoins, le collage du support 116 à l'aide de l'adhésif requiert un simple collage par mise en contact, ou la mise en œuvre d'une étape de lamination supplémentaire. Le support 116 peut être un support composite et peut comporter un nid d'abeille en aluminium pris en sandwich entre deux peaux de carbone du support 116, le premier élément de protection 105 étant collé sur une des deux peaux en carbone du support.

Il est à présent décrit un exemple particulier du deuxième mode de réalisation. Dans cet exemple : chaque couche de primaire d'accroché est en Wacker^{®} Primer G 790 et présente une épaisseur de 1 µm à 10 µm pour un grammage allant de 5 g/m² à 50 g/m²; chaque couche d'adhésion additionnelle ou non et chaque couche de collage additionnelle ou non, ci-après appelée couche de matériau polymère réticulable, est en silicone liquide (notamment en Sylgard ^{®} 184 de Dow Corning) et présente une épaisseur de 50 µm ; chaque film d'encapsulation est formé par un film réticulé en Elastosil ^{®} de l'entreprise Wacker et présente une épaisseur de 100 µm. Le procédé de fabrication comporte la formation de première et deuxième portions de l'empilement 102 destinées à former, avec une cellule photovoltaïque 100 ou des rangées de cellules photovoltaïques, l'empilement 102. La formation de la première portion comporte successivement : un traitement corona d'un panneau de verre de 100 µm d'épaisseur et de dimensions 20 cm par 20 cm ; un dépôt d'une couche de primaire d'accroché sur une face du panneau ayant subi le traitement corona, cette couche de primaire d'accroché est séchée pendant au moins 30 minutes ; un dépôt d'une première couche de matériau polymère réticulable sur la couche de primaire d'accroché, par exemple au pinceau ; un positionnement d'un film d'encapsulation à base d'un matériau polymère réticulé au moins à son point de gel sur la première couche de matériau polymère réticulable ; un dépôt d'une deuxième couche de matériau polymère réticulable sur ce film d'encapsulation, par exemple au pinceau ; un positionnement d'une cellule photovoltaïque, préalablement enduite de primaire d'accroché en faces avant et arrière, sur la deuxième couche de matériau polymère réticulable. La formation de la deuxième portion de l'empilement comporte successivement : un traitement corona d'un film de polyimide (par exemple un film polyimide DUPONT^{™} KAPTON^{®} HN) présentant une épaisseur de 50 µm et des dimensions de 20 cm par 20 cm ; un dépôt d'une couche de primaire d'accroché sur une face du film de polyimide ayant subi le traitement corona, cette couche de primaire d'accroché est séchée pendant au moins 30 minutes ; un dépôt d'une première couche de matériau polymère réticulable sur la couche de primaire d'accroché, par exemple au pinceau ; un positionnement d'un film d'encapsulation additionnel à base d'un matériau polymère réticulé au moins à son point de gel sur la première couche de matériau polymère réticulable ; un dépôt d'une deuxième couche de matériau polymère réticulable sur ce film d'encapsulation additionnel, par exemple au pinceau. Les deux portions sont ensuite associées pour former l'empilement en mettant en contact la deuxième couche de matériau polymère réticulable de la deuxième portion avec la cellule photovoltaïque. Ensuite, l'empilement est laminé par exemple sous vide de 1 mbar à 140°C pendant 20 minutes en mettant en contact le panneau de verre avec la table du laminateur. Selon le besoin, l'empilement laminé peut directement être utilisé en tant que module photovoltaïque ou être associé à un support rigide.

Selon un premier cas de l'exemple particulier du deuxième mode de réalisation, l'empilement laminé est à nouveau placé sur la table du laminateur avec le panneau de verre vers le bas et le film de polyimide vers le haut. Un film de 200 µm de ionomère est placé sur le film de polyimide, puis le support composite tel que décrit précédemment est placé sur le film de ionomère. Le tout est alors laminé par exemple sous vide de 1 mbar à 150°C pendant 20 minutes.

Selon un deuxième cas de l'exemple particulier du deuxième mode de réalisation, une couche de primaire d'accroché est formée sur le film de polyimide de l'empilement laminé, et une couche de primaire d'accroché est formée sur le support composite tel que décrit précédemment, chacune de ces couches de primaire d'accroche est séchée pendant 30 minutes. Ensuite, une couche de silicone liquide, notamment en Sylgard ^{®} 184, est déposée sur le primaire d'accroché formé sur le film de polyimide, puis est mise en contact avec le primaire d'accroché du support composite. Selon le résultat de la précédente lamination de l'empilement, l'épaisseur de la couche de silicone liquide peut être dépendante de l'épaisseur de la cellule photovoltaïque, par exemple l'épaisseur de la couche de silicone liquide peut être de 50 µm à l'aplomb de la cellule photovoltaïque et de 200 µm à la périphérie de la cellule photovoltaïque du fait de la déformation du film de polyimide. Le tout est ensuite mis sous presse pour solliciter le support composite vers le panneau de verre à l'aide d'une pression de 20 kg/m². Le tout mis sous presse est alors chauffé à 100°C pendant 45 minutes pour permettre la réticulation du silicone.

Selon un troisième mode de réalisation, par exemple tel qu'illustré en figure 15, tout particulièrement adapté pour une application spatiale du module photovoltaïque 100, la cellule photovoltaïque 101 est collée à un substrat 118, ce substrat 118 est notamment souple. Par « substrat 118 souple », il est notamment entendu que le substrat 118 présente un coefficient de drapé compris entre 0 et 0,8, ainsi le substrat 118 est de préférence un tissu. Notamment, c'est la face arrière de la cellule photovoltaïque 101 qui est collée à ce substrat 118. Ceci permet d'obtenir un module photovoltaïque 100 léger et présentant une souplesse adéquate. La souplesse du substrat 118 permet de former un module photovoltaïque 100 qui peut être aisément plié ou déployé.

En ce sens, le troisième mode de réalisation peut être tel que la formation de l'empilement 102 comporte une étape de fourniture du substrat 118 souple comportant au moins une portion imprégnée, ou étant imprégné en totalité, par du matériau polymère réticulable, c'est-à-dire que le matériau polymère réticulable imprégnant le tissu est à l'état liquide. Par la suite, la formulation « substrat imprégné » englobe tout aussi bien l'imprégnation (et plus particulièrement le résultat de l'imprégnation) de la portion du substrat ou de la totalité du substrat par le matériau polymère réticulable. Par ailleurs, le procédé de fabrication comporte une étape de mise en contact de la face arrière de la cellule photovoltaïque 101 avec la portion imprégnée. Ici, la face arrière est opposée à la face avant de la cellule photovoltaïque 101, ladite face avant étant en contact avec la couche 104 d'adhésion au sein de l'empilement 102. Ainsi, l'étape de réticulation comporte la réticulation du matériau polymère réticulable imprégnant le substrat 118, notamment simultanément à la réticulation du matériau polymère réticulable de la couche 104 d'adhésion, d'où il résulte l'encapsulation de la cellule photovoltaïque 101. Ici, le film 103 d'encapsulation et la couche 104 réticulable dans son état réticulé sont transparents.

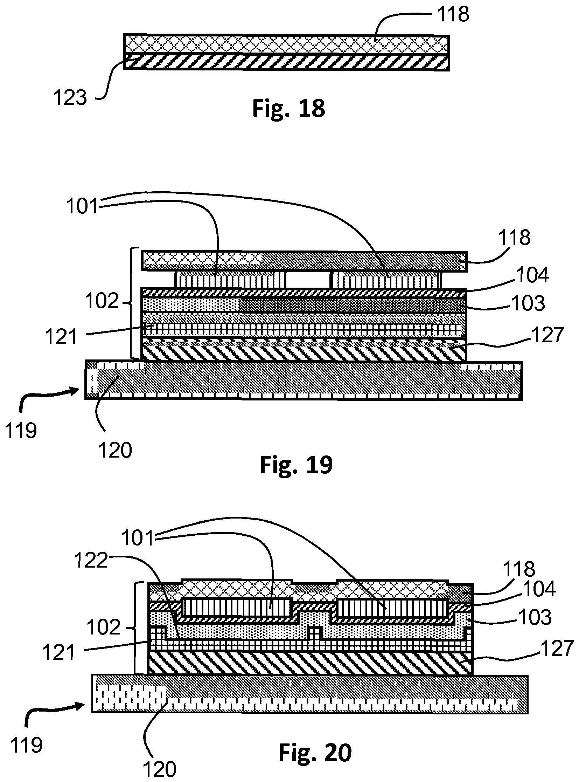

Selon un développement de ce troisième mode de réalisation, le procédé de fabrication peut comporter l'étape de lamination (figures 16, 19 et 20), dans le laminateur 119, de l'empilement 102 agencé de sorte que la face avant de la cellule photovoltaïque 101 soit orientée vers la table 120 du laminateur 119. Cet empilement 102 comporte une nappe 121 molle (c'est-à-dire en matériau déformable), par exemple en silicone, agencée entre le film 103 d'encapsulation et la table 120 du laminateur 119 de sorte qu'au cours de l'étape de lamination un rapprochement de la cellule photovoltaïque 101 (passage de la figure 19 à la figure 20) par rapport à la table du laminateur 120 provoque une déformation de la nappe 121 molle par une formation d'un enfoncement 122 localisé dans la nappe 121 molle et ayant la forme de la cellule photovoltaïque 101. Ceci présente l'avantage de limiter la déformation du substrat 118, et donc de la face arrière du module photovoltaïque 100 formée par la face du substrat 118 opposée à la cellule photovoltaïque 101. La lamination permet à la fois la déformation du substrat 118 et du film 103 d'encapsulation pour épouser la cellule photovoltaïque 101. La déformation de la nappe 121 molle permet de limiter la déformation du substrat 118 lors de la lamination pour assurer une homogénéité satisfaisante du matériau polymère réticulable imprégnant substrat 118.

La nappe 121 molle peut être en silicone et peut présenter une épaisseur comprise entre 0,3 mm et 5 mm. Une telle nappe 121 molle peut présenter une dureté comprise entre 10 et 50 sur l'échelle Shore A. Ces caractéristiques de la nappe 121 molle permettent d'obtenir la déformation souhaitée de cette dernière, au cours de l'étape de lamination, par enfoncement de la cellule photovoltaïque 101 dans la nappe 121 molle d'où il résulte la formation de l'enfoncement 112.

Il est à présent décrit un exemple particulier de ce troisième mode de réalisation pour lequel il est formé un empilement 102 (figure 16) comportant successivement un premier support rigide 123, le substrat 118 souple imprégné du matériau polymère réticulable, la cellule photovoltaïque 101, la couche 104 d'adhésion, le film 103 d'encapsulation, la nappe 121 molle et un deuxième support rigide 127. Les premier et deuxième support rigide 123, 127 peuvent être chacun un panneau de verre. Pour imprégner le substrat 118, il peut être formé, lors de la formation de l'empilement 102, une couche 126 de matériau polymère réticulable par exemple sur le premier support rigide 123 (figure 17), avant de reporter le substrat 118 sur cette couche 126 de matériau polymère réticulable qui est alors absorbée par le substrat 118 (figure 18). Du matériau polymère réticulable est ensuite ajouté, par exemple à l'aide d'un pinceau, sur le substrat 118 pour parfaire son imprégnation. Après l'ajout du matériau polymère réticulable sur le substrat 118, ce substrat 118, alors enduit de matériau polymère réticulable, est « lissé » à l'aide d'une raclette ou d'un débulleur pour homogénéiser son imprégnation en matériau polymère réticulable : le lissage correspond donc notamment à venir racler la surface du substrat 118. L'imprégnation du substrat 118 peut alternativement être réalisée par vaporisation, par trempage ou par enduction. La cellule photovoltaïque 101, de préférence recouverte d'un primaire d'accroché, est ensuite positionnée face arrière sur la deuxième face du substrat 118 souple imprégné (figure 16). Ensuite, il est empilé (figure 16) successivement sur la cellule photovoltaïque 101 : le film 103 d'encapsulation dont la première face est enduite par la couche 104 d'adhésion, ladite couche 104 d'adhésion étant en contact avec la cellule photovoltaïque 101 ; la nappe 121 molle ; le deuxième support 127 rigide. L'ensemble est ensuite retourné sur la table 120 du laminateur (figure 19) en mettant en contact le deuxième support rigide 127 avec la table du laminateur, puis le premier support rigide 123 est retiré d'où il résulte la formation de l'empilement 102 à laminer comportant successivement depuis la table 120 du laminateur : le deuxième support 127 rigide, la nappe 121 molle, le film 103 d'encapsulation, la couche 104 d'adhésion, la cellule photovoltaïque 101, le substrat 118 souple imprégné. L'empilement 102 ainsi formé est ensuite laminé à chaud dans le laminateur 119 à une température de réticulation pour réticuler le matériau polymère réticulable de la couche 104 d'adhésion et le matériau polymère réticulable imprégnant le substrat 118. En sortie du laminateur, le deuxième support 127 rigide et la nappe 121 molle sont retirés d'où il résulte l'obtention de l'empilement 102 de la figure 15 dont la déformation du substrat 118 souple est limitée. Les premier et deuxième support 123, 127 rigide ont notamment pour fonction de permettre la manipulation de l'ensemble de l'empilement 102, par exemple en permettant son retournement.

Le tissu formant le substrat 118 souple peut présenter un grammage compris entre 20 g/m² et 300g/m².

Comme évoqué précédemment, le substrat 118 souple peut être tissé, c'est-à-dire être un tissu. Un tel tissu peut être choisi parmi un tissu de fibres de verre, un tissu de fibres d'aramide comme le Kevlar^{®} (le Kevlar^{®} correspondant à du poly(p-phénylènetéréphtalamide) aussi appelé PPD-T) ou comme le Twaron^{®} correspondant à un p-phénylène téréphtalamide (PpPTA), et un tissu de polyester aromatique tel que le Vectran^{®}. Ces tissus sont tout particulièrement adaptés pour coller chaque cellule photovoltaïque au substrat 118 tout en conservant une souplesse du substrat 118 après réticulation du matériau polymère réticulable collant dans son état réticulé les cellules photovoltaïques.

Le matériau polymère réticulable destiné à imprégner le substrat 118 peut être à base de silicone, comme par exemple du Sylgard ^{®} 184 (en respectant par exemple un ration 10 :1 respectivement pour le composant A et le composant B), ou du 93-500 de l'entreprise Dow Corning, ou encore de la colle silicone RTV-S691 de l'entreprise Wacker. Par exemple, il faut compter au moins 100 g de matériau polymère réticulable par mètre carré de substrat 118 à imprégner dans le cas du substrat 118 formé par un tissu de fibres de verre de 100 g/m². Cette quantité minimale peut bien entendu varier en fonction des caractéristiques du substrat 118, notamment de son épaisseur, de la densité de ses mailles, ou de sa tension de surface. Ce produit réticulable est dégazé, par exemple dans une cloche à vide avant de l'utiliser.

De manière applicable à tout ce qui a été décrit précédemment, le matériau polymère réticulable de chaque couche d'adhésion ou de collage (additionnelle ou non), le matériau de chaque film d'encapsulation (additionnel ou non) sont préférentiellement de même nature. Par même nature, on entend qu'ils peuvent avoir été obtenus à partir d'une même formulation de matériau polymère réticulable et réticulés dans les mêmes conditions (température, temps, pression), mais le cas échéant à des moments différents. Ils présentent en conséquence des propriétés mécaniques et optiques similaires. Par exemple, des coefficients d'expansion thermique similaires limitent les risques de casse et de délamination du module photovoltaïque 100. Des indices de réfractions similaires limitent les réflexions aux interfaces et par conséquent augmente le rendement de la cellule photovoltaïque 101. Le cas échéant ceci s'applique aussi au matériau polymère réticulable imprégnant le substrat 118. L'utilisation d'une même formulation de matériau polymère réticulable permet une meilleure cohésion de l'enveloppe d'encapsulation en favorisant l'accroche des matériaux pour éviter la délamination de l'empilement 102.

De manière générale, un primaire d'accroché au sens de la présente description est un matériau adoptant, de préférence, une forme de couche facilitant l'accroche du matériau polymère réticulable d'une couche correspondante, ce primaire d'accroché peut comporter des silanes et des siloxanes réactives.

Bien entendu, il résulte de la présente description que toute architecture de module photovoltaïque 100 obtenue selon le procédé de fabrication décrit peut être objet de l'invention. En ce sens, l'invention est aussi relative à un module photovoltaïque 100 comportant l'empilement 102 pour lequel tout matériau polymère réticulable a été réticulé. Cet empilement 102 comporte la cellule photovoltaïque 101 et un bicouche. Le bicouche est formé par/comporte le film 103 d'encapsulation à base d'un matériau polymère réticulé et la couche 104 d'adhésion à base d'un matériau polymère réticulé, la couche 104 d'adhésion étant agencée entre le film 103 d'encapsulation et la cellule photovoltaïque 101. La couche 104 d'adhésion colle le film 103 d'encapsulation à la cellule photovoltaïque 101. Un avantage d'un tel module photovoltaïque 100 est que l'épaisseur de l'encapsulant est homogène. Le cas échéant, un tel module photovoltaïque 100 peut être pliable et utilisable à des températures allant de -200°C à 200°C, dépourvu de bulles il est utilisable dans un environnement spatial sous vide.

Plus particulièrement, l'empilement 102 du module photovoltaïque 100 peut comporter :
- la couche 104 d'adhésion à base d'un matériau polymère réticulé (c'est-à-dire la couche 104 d'adhésion dont le matériau polymère réticulable a été réticulé au cours du procédé de fabrication),
- le film 103 d'encapsulation,
- le premier élément 105 de protection (notamment formé par un film de polyimide),
- la couche 110 de collage à base d'un matériau polymère réticulé (c'est-à-dire la couche 110 de collage dont le matériau polymère réticulable a été réticulé au cours du procédé de fabrication), la couche 110 de collage collant le film 103 d'encapsulation au premier élément 105 de protection,
- la couche 108 d'adhésion additionnelle à base d'un matériau polymère réticulé (c'est-à-dire la couche 108 d'adhésion additionnelle dont le matériau polymère réticulable a été réticulé au cours du procédé de fabrication),
- le film 107 d'encapsulation additionnel à base d'un matériau polymère réticulé, ledit film 107 d'encapsulation additionnel étant collé à la cellule photovoltaïque 101 par la couche 108 d'adhésion additionnelle,
- la couche 111 de collage additionnelle à base d'un matériau polymère réticulé (c'est-à-dire la couche 111 de collage additionnelle dont le matériau polymère réticulable a été réticulé au cours du procédé de fabrication),
- le deuxième élément 109 de protection (notamment en verre) collé au film 107 d'encapsulation additionnel par la couche 111 de collage additionnelle. Ici les premier et deuxième éléments de protection 105, 109 permettent d'assurer la protection du module telle que décrite précédemment. Autrement dit, l'empilement 102 peut comporter successivement le premier élément de protection 105, la couche 110 de collage, le film 103 d'encapsulation, la couche 104 d'adhésion, la cellule photovoltaïque 101, la couche 108 d'adhésion additionnelle, le film 107 d'encapsulation additionnel, la couche 111 de collage additionnelle, le deuxième élément de protection 109.

Selon un perfectionnement (figure 12) du module photovoltaïque 100, le film 103 d'encapsulation et le film 107 d'encapsulation additionnel sont troués de sorte que : les couches 104, 110 d'adhésion et de collage sont reliées entre elles au niveau des trous 112 du film 103 d'encapsulation, notamment par du matériau polymère réticulé présent dans lesdits trous 112 du film 103 d'encapsulation ; les couches 108, 111 d'adhésion et de collage additionnelles sont reliées entre elles au niveau des trous 113 du film 107 d'encapsulation additionnel, notamment par du matériau polymère réticulé présent dans lesdits trous 113 du film 107 d'encapsulation additionnel. Ceci permet de limiter la délamination du module photovoltaïque 100 au cours du temps.

Selon une réalisation le module photovoltaïque comporte le substrat 118 souple collé à la face arrière de la cellule photovoltaïque 101 par du matériau polymère réticulé présent dans au moins une portion du substrat 118, et la cellule photovoltaïque 101 comporte une face avant en contact avec la couche 104 d'adhésion. Ceci permet l'obtention d'un module photovoltaïque 101 souple et par exemple dépliable.

Bien entendu, tout ce qui a été décrit en relation avec le procédé de fabrication peut s'appliquer au module photovoltaïque, et inversement.

L'invention présente une application industrielle dans la fabrication de modules photovoltaïques terrestre et spatiaux car elle permet d'encapsuler une ou plusieurs cellules photovoltaïques de type III-V, silicium, ou multijonction. L'invention peut aussi permettre d'encapsuler des cellules photovoltaïques de type couches minces comme par exemple CIGS (pour Cuivre, indium, gallium et sélénium), CdTe (pour tellurure de cadmium), OPV pour cellules photovoltaïques organiques.

## Revendications

1. Procédé de fabrication d'un module photovoltaïque (100) comportant au moins une cellule photovoltaïque (101), le procédé de fabrication comportant une étape d'encapsulation de la cellule photovoltaïque (101) comprenant la formation d'un empilement (102) comportant :
- la cellule photovoltaïque (101),
- un film (103) d'encapsulation à base d'un matériau polymère réticulé au moins à son point de gel,
- une couche (104) d'adhésion à base d'un matériau polymère réticulable, la couche (104) d'adhésion étant destinée à coller le film (103) d'encapsulation à la cellule photovoltaïque (101),
et le procédé de fabrication comportant :
- une étape de réticulation comportant la réticulation du matériau polymère réticulable de la couche (104) d'adhésion, le procédé étant **caractérisé par**
- une étape de formation de la couche (104) d'adhésion sur le film (103) d'encapsulation avant de mettre en contact la couche (104) d'adhésion avec la cellule photovoltaïque (101).

2. Procédé de fabrication selon la revendication 1, **caractérisé en ce que** le matériau polymère réticulé au moins à son point de gel du film (103) d'encapsulation et le matériau polymère réticulable de la couche (104) d'adhésion sont respectivement choisi parmi la famille des silicones.

3. Procédé de fabrication selon l'une quelconque des revendications précédentes, **caractérisé en ce que** l'étape d'encapsulation comporte une étape de lamination de l'empilement (102) mettant en œuvre l'étape de réticulation.

4. Procédé de fabrication selon l'une quelconque des revendications précédentes, caractérisé ce que la formation de l'empilement (102) est telle que ledit empilement (102) comporte :
- une première partie comportant ledit film (103) d'encapsulation et ladite couche (104) d'adhésion,
- une deuxième partie comportant un film (107) d'encapsulation additionnel à base d'un matériau polymère réticulé au moins à son point de gel et une couche (108) d'adhésion additionnelle à base d'un matériau polymère réticulable destinée à coller le film (107) d'encapsulation additionnel à la cellule (101) photovoltaïque,
- la cellule photovoltaïque (100) interposée entre les première et deuxième parties,
et en ce que l'étape de réticulation comporte la réticulation du matériau polymère réticulable de la couche (108) d'adhésion additionnelle, et en ce qu'il résulte de l'étape de réticulation l'encapsulation de la cellule photovoltaïque (101) entre le film (103) d'encapsulation et le film (107) d'encapsulation additionnel.

5. Procédé de fabrication selon la revendication précédente, **caractérisé en ce que** la formation de l'empilement (102) est telle que l'empilement (102) comporte des premier et deuxième éléments (105, 109) de protection entre lesquels sont agencées les première et deuxième parties de l'empilement (102), la première partie de l'empilement (102) comportant une couche (110) de collage à base d'un matériau polymère réticulable destinée coller le film (103) d'encapsulation au premier élément (105) de protection, et la deuxième partie comportant une couche (111) de collage additionnelle à base d'un matériau polymère réticulable destinée à coller le film (107) d'encapsulation additionnel au deuxième élément (109) de protection, et **en ce que** l'étape de réticulation comporte la réticulation du matériau polymère réticulable de la couche (110) de collage et du matériau polymère réticulable de la couche de collage (111) additionnelle de telle sorte qu'il résulte de l'étape de réticulation la formation d'une enveloppe d'encapsulation de la cellule photovoltaïque (101) collée aux premier et deuxième éléments (105, 109) de protection.

6. Procédé de fabrication selon la revendication précédente, **caractérisé en ce que** le film (103) d'encapsulation et le film (107) d'encapsulation additionnel sont troués de sorte qu'au sein de l'empilement (102) :
- les couches d'adhésion et de collage (104, 110) sont reliées entre elles au niveau des trous (112) du film (103) d'encapsulation, notamment par du matériau polymère réticulable (114a) présent dans lesdits trous (112),
- les couches d'adhésion et de collage additionnelles (108, 111) sont reliées entre elles au niveau des trous (113) du film (107) d'encapsulation additionnel, notamment par du matériau polymère réticulable (114b) présent dans lesdits trous (113).

7. Procédé de fabrication selon la revendication 3 et l'une quelconque des revendications 5 à 6, **caractérisé en ce qu'**au moins l'un des premier et deuxième élément (105, 109) de protection est déformable de telle sorte qu'il subit une déformation au cours de l'étape de lamination.

8. Procédé de fabrication selon la revendication précédente, **caractérisé en ce qu'**après l'étape de lamination, il comporte une étape de collage d'un support (116) sur le premier élément (105) de protection déformé ou sur le deuxième élément (109) de protection déformé.

9. Procédé de fabrication selon l'une quelconque des revendications 1 à 3, **caractérisé en ce que** la formation de l'empilement (102) comporte :
- une étape de fourniture d'un substrat (118) souple comportant au moins une portion imprégnée par du matériau polymère réticulable,
- une étape de mise en contact d'une face arrière de la cellule photovoltaïque (101) avec la portion imprégnée, la face arrière étant opposée à une face avant de la cellule photovoltaïque (101), ladite face avant étant en contact avec la couche (104) d'adhésion au sein de l'empilement (102),
et **en ce que** l'étape de réticulation comporte la réticulation du matériau polymère réticulable imprégnant le substrat (118) d'où il résulte l'encapsulation de la cellule photovoltaïque (101).

10. Procédé de fabrication selon l'une quelconque des revendications précédentes, **caractérisé en ce que** la viscosité du matériau polymère réticulable de la couche (104) d'adhésion est strictement supérieure à 5 Pa.s à une température de 25°C et inférieure ou égale à 50 Pa.s à une température de 25°C.

11. Procédé de fabrication selon l'une quelconque des revendications 1 à 9, **caractérisé en ce que** la viscosité du matériau polymère réticulable de la couche (104) d'adhésion est strictement supérieure à 5 Pa.s à une température de 25°C et inférieure ou égale à 10 Pa.s à une température de 25°C.

## Patentansprüche

1. Verfahren zur Herstellung eines Photovoltaikmoduls (100), das mindestens eine Photovoltaikzelle (101) umfasst, wobei das Herstellungsverfahren einen Schritt der Einkapselung der Photovoltaikzelle (101) aufweist, umfassend die Herstellung eines Stapels, der Folgendes umfasst:
- die Photovoltaikzelle (101),
- einen Einkapselungsfilm (103) auf der Basis eines Polymermaterials, das zumindest an seinem Gelpunkt vernetzt ist, und
- eine Haftschicht (104) auf der Basis eines vernetzbaren Polymermaterials, wobei die Haftschicht (104) dazu dient, den Einkapselungsfilm (103) an die Photovoltaikzelle (101) zu kleben,
und das Herstellungsverfahren Folgendes umfasst:
- einen Vernetzungsschritt, der das Vernetzen des vernetzbaren Polymermaterials der Haftschicht (104) umfasst, wobei das Verfahren **gekennzeichnet ist durch**
- einen Schritt der Herstellung der Haftschicht (104) auf dem Einkapselungsfilm (103), bevor die Haftschicht (104) mit der Photovoltaikzelle (101) in Kontakt gebracht wird.

2. Herstellungsverfahren nach Anspruch 1, **dadurch gekennzeichnet, dass** das zumindest an seinem Gelpunkt vernetzte Polymermaterial des Einkapselungsfilms (103) und das vernetzbare Polymermaterial der Haftschicht (104) jeweils aus der Familie der Silikone ausgewählt sind.

3. Herstellungsverfahren nach einem der vorhergehenden Ansprüche, **dadurch gekennzeichnet, dass** der Einkapselungsschritt einen Schritt der Lamination des Stapels (102) umfasst, bei dem der Vernetzungsschritt eingesetzt wird.

4. Herstellungsverfahren nach einem der vorhergehenden Ansprüche, **dadurch gekennzeichnet, dass** die Herstellung des Stapels (102) derart ist, dass der Stapel (102) Folgendes aufweist:
- einen ersten Teil, der den Einkapselungsfilm (103) und die Haftschicht (104) umfasst,
- einen zweiten Teil, der einen zusätzlichen Einkapselungsfilm (107) auf der Basis eines Polymermaterials, das zumindest an seinem Gelpunkt vernetzt ist, und eine zusätzliche Haftschicht (108) auf der Basis eines vernetzbaren Polymermaterials umfasst, die dazu dient, den zusätzlichen Einkapselungsfilm (107) an die Photovoltaikzelle zu kleben,
- die zwischen den ersten und den zweiten Teil eingebrachte Photovoltaikzelle (100), und dadurch, dass der Vernetzungsschritt die Vernetzung des vernetzbaren Polymermaterials der zusätzlichen Haftschicht (108) umfasst, und dadurch, dass der Vernetzungsschritt zur Einkapselung der Photovoltaikzelle (101) zwischen dem Einkapselungsfilm (103) und dem zusätzlichen Einkapselungsfilm (107) führt.

5. Herstellungsverfahren nach dem vorhergehenden Anspruch, **dadurch gekennzeichnet, dass** die Herstellung des Stapels (102) derart ist, dass der Stapel (102) ein erstes und ein zweites Schutzelement (105, 109) aufweist, zwischen denen der erste und der zweite Teil des Stapels (102) angeordnet sind, wobei der erste Teil des Stapels (102) eine Klebeschicht (110) auf der Basis eines vernetzbaren Polymermaterials umfasst, die dazu bestimmt ist, den Einkapselungsfilm (103) an das erste Schutzelement (105) zu kleben, und wobei der zweite Teil eine zusätzliche Klebeschicht (111) auf der Basis eines vernetzbaren Polymermaterials aufweist, die dazu bestimmt ist, den zusätzlichen Einkapselungsfilm (107) an das zweite Schutzelement (109) zu kleben, und dadurch, dass der Vernetzungsschritt die Vernetzung des vernetzbaren Polymermaterials der Klebeschicht (110) und des vernetzbaren Polymermaterials der zusätzlichen Klebeschicht (111) umfasst, derart, dass der Vernetzungsschritt zur Herstellung einer Einkapselungshülle der Photovoltaikzelle (101) führt, die an das erste und das zweite Schutzelement (105, 109) geklebt ist.

6. Herstellungsverfahren nach dem vorhergehenden Anspruch, **dadurch gekennzeichnet, dass** der Einkapselungsfilm (103) und der zusätzliche Einkapselungsfilm (107) mit Löchern versehen sind, derart, dass im Inneren des Stapels (102):
- die Haft- und die Klebeschicht (104, 110) an den Löchern (112) des Einkapselungsfilms (103), insbesondere durch das in den Löchern (112) vorhandene vernetzbare Polymermaterial (114a), miteinander verbunden sind,
- die zusätzliche Haft- und Klebeschicht (108, 111) an den Löchern (113) des zusätzlichen Einkapselungsfilms (107), insbesondere durch das in den Löchern (113) vorhandene vernetzbare Polymermaterial (114b), miteinander verbunden sind.

7. Herstellungsverfahren nach Anspruch 3 und einem der Ansprüche 5 bis 6, **dadurch gekennzeichnet, dass** mindestens eines aus dem ersten und dem zweiten Schutzelement (105, 109) derart verformbar ist, dass es während des Laminationsschritts einer Verformung unterliegt.

8. Herstellungsverfahren nach dem vorhergehenden Anspruch, **dadurch gekennzeichnet, dass** es nach dem Laminationsschritt einen Schritt des Klebens eines Trägers (116) auf das verformte erste Schutzelement (105) oder auf das verformte zweite Schutzelement (109) umfasst.

9. Herstellungsverfahren nach einem der Ansprüche 1 bis 3, **dadurch gekennzeichnet, dass** die Herstellung des Stapels (102) Folgendes umfasst:
- einen Schritt der Bereitstellung eines flexiblen Substrats (118), das mindestens einen mit dem vernetzbarem Polymermaterial imprägnierten Teil umfasst, und
- einen Schritt des Inkontaktbringens einer Rückseite der Photovoltaikzelle (101) mit dem imprägnierten Teil, wobei die Rückseite einer Vorderseite der Photovoltaikzelle (101) gegenüberliegt, wobei die Vorderseite mit der Haftschicht (104) im Inneren des Stapels (102) in Kontakt ist,
und dadurch, dass der Vernetzungsschritt die Vernetzung des vernetzbaren Polymermaterials, das das Substrat (118) imprägniert, umfasst, was zur Einkapselung der Photovoltaikzelle (101) führt.

10. Herstellungsverfahren nach einem der vorhergehenden Ansprüche, **dadurch gekennzeichnet, dass** die Viskosität des vernetzbaren Polymermaterials der Haftschicht (104) strikt höher als 5 Pa·s bei einer Temperatur von 25 °C und niedriger oder gleich 50 Pa·s bei einer Temperatur von 25 °C ist.

11. Herstellungsverfahren nach einem der Ansprüche 1 bis 9, **dadurch gekennzeichnet, dass** die Viskosität des vernetzbaren Polymermaterials der Haftschicht (104) strikt höher als 5 Pa·s bei einer Temperatur von 25 °C und niedriger oder gleich 10 Pa·s bei einer Temperatur von 25 °C ist.

## Claims

1. Method for manufacturing a photovoltaic module (100) comprising at least one photovoltaic cell (101), the manufacturing method comprising a step of encapsulating the photovoltaic cell (101) comprising the formation of a stack (102) comprising:
- the photovoltaic cell (101),
- an encapsulation film (103) based on a polymer material crosslinked at least at its gel point,
- an adhesion layer (104) based on a crosslinkable polymer material, the adhesion layer (104) being intended to bond the encapsulation film (103) to the photovoltaic cell (101),
and the manufacturing method comprising:
- a crosslinking step comprising the crosslinking of the crosslinkable polymer material of the adhesion layer (104),
the method being **characterized by** a step of forming the adhesion layer (104) on the encapsulation film (103) before bringing the adhesion layer (104) into contact with the photovoltaic cell (101).

2. Manufacturing method according to Claim 1, **characterized in that** the polymer material crosslinked at least at its gel point of the encapsulation film (103) and the crosslinkable polymer material of the adhesion layer (104) are respectively chosen from among the silicone family.

3. Manufacturing method according to either one of the preceding claims, **characterized in that** the encapsulation step comprises a step of laminating the stack (102) implementing the crosslinking step.

4. Manufacturing method according to any one of the preceding claims, **characterized in that** the formation of the stack (102) is such that said stack (102) comprises:
- a first part comprising said encapsulation film (103) and said adhesion layer (104),
- a second part comprising an additional encapsulation film (107) based on a polymer material crosslinked at least at its gel point and an additional adhesion layer (108) based on a crosslinkable polymer material intended to bond the additional encapsulation film (107) to the photovoltaic cell (101),
- the photovoltaic cell (100) interposed between the first and second parts, and **in that** the crosslinking step comprises the crosslinking of the crosslinkable polymer material of the additional adhesion layer (108), and **in that** the crosslinking step results in the encapsulation of the photovoltaic cell (101) between the encapsulation film (103) and the additional encapsulation film (107).

5. Manufacturing method according to the preceding claim, **characterized in that** the formation of the stack (102) is such that the stack (102) comprises first and second protective elements (105, 109) between which the first and second parts of the stack (102) are arranged, the first part of the stack (102) comprising a bonding layer (110) based on a crosslinkable polymer material intended to bond the encapsulation film (103) to the first protective element (105), and the second part comprising an additional bonding layer (111) based on a crosslinkable polymer material intended to bond the additional encapsulation film (107) to the second protective element (109), and **in that** the crosslinking step comprises the crosslinking of the crosslinkable polymer material of the bonding layer (110) and of the crosslinkable polymer material of the additional bonding layer (111) such that the crosslinking step results in the formation of an encapsulation envelope for the photovoltaic cell (101) bonded to the first and second protective elements (105, 109).

6. Manufacturing method according to the preceding claim, **characterized in that** the encapsulation film (103) and the additional encapsulation film (107) are perforated such that within the stack (102):
- the adhesion and bonding layers (104, 110) are connected to one another at the holes (112) in the encapsulation film (103), in particular by crosslinkable polymer material (114a) present in said holes (112),
- the additional adhesion and bonding layers (108, 111) are connected to one another at the holes (113) in the additional encapsulation film (107), in particular by crosslinkable polymer material (114b) present in said holes (113).

7. Manufacturing method according to Claim 3 and either one of Claims 5 and 6, **characterized in that** at least one of the first and second protective elements (105, 109) is deformable such that it undergoes a deformation during the lamination step.

8. Manufacturing method according to the preceding claim, **characterized in that** after the lamination step, it comprises a step of bonding a support (116) to the deformed first protective element (105) or to the deformed second protective element (109).

9. Manufacturing method according to any one of Claims 1 to 3, **characterized in that** the formation of the stack (102) comprises:
- a step of providing a flexible substrate (118) comprising at least one portion impregnated with crosslinkable polymer material,
- a step of bringing a back face of the photovoltaic cell (101) into contact with the impregnated portion, the back face being opposite a front face of the photovoltaic cell (101), said front face being in contact with the adhesion layer (104) within the stack (102),
and **in that** the crosslinking step comprises the crosslinking of the crosslinkable polymer material impregnating the substrate (118) resulting in the encapsulation of the photovoltaic cell (101).

10. Manufacturing method according to any one of the preceding claims, **characterized in that** the viscosity of the crosslinkable polymer material of the adhesion layer (104) is strictly higher than 5 Pa.s at a temperature of 25°C and lower than or equal to 50 Pa.s at a temperature of 25°C.

11. Manufacturing method according to any one of Claims 1 to 9, **characterized in that** the viscosity of the crosslinkable polymer material of the adhesion layer (104) is strictly higher than 5 Pa.s at a temperature of 25°C and lower than or equal to 10 Pa.s at a temperature of 25°C.
